Europäisches Patentamt

European Patent Office

Office européen des brevets

(19)

(11) Veröffentlichungsnummer : **0 067 144**
**B1**

(12) **EUROPÄISCHE PATENTSCHRIFT**

(45) Veröffentlichungstag der Patentschrift :
25.07.84

(51) Int. Cl.³ : **E 21 C 35/22**

(21) Anmeldenummer : **82890080.3**

(22) Anmeldetag : **26.05.82**

(54) **Einrichtung zum Kühlen der Meissel einer Schrämmaschine.**

(30) Priorität : **04.06.81 AT 2518/81**

(43) Veröffentlichungstag der Anmeldung :
**15.12.82 Patentblatt 82/50**

(45) Bekanntmachung des Hinweises auf die Patenterteilung : **25.07.84 Patentblatt 84/30**

(84) Benannte Vertragsstaaten :
**DE FR GB**

(56) Entgegenhaltungen :
**EP-A- 0 060 827**
**DE-A- 2 363 372**

(73) Patentinhaber : **VOEST-ALPINE Aktiengesellschaft**
**Friedrichstrasse 4**
**A-1011 Wien (AT)**

(72) Erfinder : **Zitz, Alfred**
**Granitzenweg 13b**
**A-8740 Zeltweg (AT)**
Erfinder : **Schetina, Otto, Dipl.Ing.**
**Bessemerstrasse 36**
**A-8740 Zeltweg (AT)**
Erfinder : **Wruilch, Herwig**
**Haidenweg 4**
**A-8740 Zeltweg (AT)**

(74) Vertreter : **Kretschmer, Adolf, Dipl.-Ing. et al**
**Patentanwälte Dipl.Ing. A. Kretschmer Dr. Thomas M.**
**Haffner Schottengasse 3a**
**A-1014 Wien (AT)**

**Beschreibung**

Die Erfindung bezieht sich auf eine Einrichtung zum Kühlen der Meißel einer Schrämmaschine mit einer im Bereich des Meißels angeordneten Düse für das unter Druck auszuspritzende Kühlwasser, zu welcher die Wasserzufuhr durch einen Ventilkegel absperrbar ist, wobei der Meißel am Meißelhalter entgegen einer von einer Feder und dem auf den Ventilkegel wirkenden Wasserdruck gebildeten Rückstellkraft durch den Schnittdruck begrenzt axial verschiebbar gelagert ist und der Ventilkegel mit dem Meißel durch ein Kuppelglied derart gekuppelt ist, daß er bei einer Verschiebebewegung des Meißels in Richtung des Schnittdruckes öffnet. Eine solche Einrichtung ist aus der eigenen älteren EP-A-60827 bekannt, die unter Art. 54 (3) und (4) des EPÜ fällt. Die Meißel sind beispielsweise an einem Schrämkopf oder einer Schrämwalze angeordnet. Die oben beschriebene Einrichtung ist jedem Meißel oder nur denjenigen Meißeln zugeordnet, welche höher beansprucht sind. Bei den bekannten Einrichtungen dieser Art ist die Rückstellkraft im wesentlichen durch die Kraft der Feder gebildet. Das Absperrventil ist zwar so angeordnet, daß der auf das Ventil wirkende Wasserdruck auch im Sinne des Schließens desselben wirkt, jedoch ergibt dieser nur einen kleinen Teil der Rückstellkraft. Im Falle eines Bruches der Feder ist daher das Absperrventil nicht mehr funktionsfähig. Überdies hat eine starke Feder verhältnismäßig große Baumaße zur Voraussetzung und dies ist nachteilig, da ja die Düse und damit auch das Ventil im Meißelhalter angeordnet sein muß.

Die Erfindung stellt sich nun zur Aufgabe, die Baumaße der Feder zu verringern und die Funktionsfähigkeit des Ventiles auch bei einem Bruch der Feder aufrecht zu erhalten.

Die Erfindung besteht im wesentlichen darin, daß bei einer Ausbildung, bei welcher der Ventilkegel erst bei einer vorbestimmten Belastung des Meißels öffnet, der Wasserdruck vor dem Ventilkegel multipliziert mit der durch den Wasserdruck im Schließsinne beaufschlagten wirksamen Fläche des Ventilkegels im wesentlichen der Rückstellkraft entspricht und daß die Feder nur so stark bemessen ist, daß sie bei abgesperrter Wasserzufuhr den Ventilkegel entgegen dem Gewicht des Ventilkegels und des Meißels unt entgegen den inneren Reibungswiderständen schließt. Das Absperrventil soll erst bei einer vorbestimmten Belastung des Meißels öffnen, um mit Sicherheit zu vermeiden, daß der Wasseraustritt aus der Düse auch erfolgt, wenn der Meißel mit dem Gestein nicht in Berührung ist. Wenn nun das Ventil nur dann geöffnet werden soll, wenn ein vorbestimmter Schnittdruck auf den meißel wirkt, um bei weichem Gestein, bei welchem eine Kühlung des Meißels und der Ortsbrust nicht erforderlich ist, einen Wasserverbrauch zu vermeiden, so ist eine verhältnismäßig große auf den Meißel wirkende Rückstellkraft erforderlich und diese wird nun gemäß der Erfindung durch den Wasserdruck aufgebracht. Wenn aber der Wasserdruck allein auf das Absperrventil im Schließsinne wirken würde, so wäre in der Außerbetriebsstellung des Schrämwerkzeuges beispielsweise zu Betriebsbeginn oder nach einer Reparatur die Stellung des Ventils nicht bestimmt. Es würden allein durch das Gewicht der Meißel die den oben liegenden Meißeln zugeordneten Absperrventile in der Offenstellung liegen und auch bei den anderen Ventilen wäre die Schließstellung derselben infolge der inneren Widerstände bzw. der auftretenden Reibung nicht gewährleistet. Wenn eine große Anzahl von Ventilen offen ist, würde, wenn das Schließen der Ventile durch den Wasserdruck allein erfolgen soll, eine sehr große Fördermenge der Wasserpumpe erforderlich sein, welche bei den für den laufenden Betrieb dimensionierten Wasserpumpen nicht aufgebracht werden kann. Es wäre daher die Sicherheit nicht gegeben, daß die Ventile in die richtige Arbeitsstellung gelangen. Aus diesem Grunde sind zusätzlich auf die Ventile wirkende Federn vorgesehen, welche die Schließstellung der Ventile in der Außerbetriebsstellung gewährleisten, jedoch können diese Federn so schwach dimensioniert sein, daß sie nur ausreichen, um entgegen dem Gewicht des Ventilkegels und des Meißels und entgegen den inneren Widerständen das betreffende Ventil zu schließen. Diese Federn können daher sehr schwach dimensioniert sein. Bei einem Bruch einzelner Federn ist auch die Funktionsfähigkeit der Ventile noch nicht in Frage gestellt, da ja die Rückstellkraft im wesentlichen durch den Wasserdruck aufgebracht wird und auch wenn das eine oder andere Ventil nicht in der Schließstellung gehalten wird, die Förderleistung der Pumpe immer noch ausreicht, um die betreffenden Ventile in die Schließstellung zu bringen.

Gemäß einer bevorzugten Ausführungsform der Erfindung ist die Anordnung so getroffen, daß der Ventilkegel in an sich bekannter Weise entgegen der Strömungsrichtung des Wassers öffnet und einen im Ventilgehäuse dicht geführten Ventilschaft aufweist, daß mit dem Ventilkegel ein in Strömungsrichtung hinter demselben angeordneter Kolben starr verbunden ist, der in einem Zylinder des Ventilgehäuses dicht geführt ist, wobei ein Raum zwischen Ventilkegel und Kolben über wenigstens eine Austrittsöffnung für das Wasser mit dem Raum vor der Düse verbunden ist, und daß der Durchmesser des Kolbens größer ist als der Durchmesser des Schaftes des Ventilkegels. Bei geschlossenen Absperrventilen wirkt hiebei der Wasserdruck auf eine Ringfläche, deren Größe dem Querschnitt des Ventilsitzes abzüglich des Querschnittes des Ventilschaftes entspricht, und erst bei Überwindung des auf diese Ringfläche wirkenden Wasserdruckes wird das Ventil geöffnet. Bei geöffneten Ventilen jedoch wirkt der Wasserdruck auf eine Ringfläche, deren Größe dem Querschnitt des Kolbens abzüglich des Querschnittes des Ventilschaftes entspricht. Der auf diese Ringfläche wirkende Wasserdruck bestimmt nun die Rückstellkraft bei offenem Absperrventil und da der Durchmesser des Kolbens größer ist als der Durchmesser des Schaftes, wird das Absperrventil offen gehalten. Erst wenn diese Rückstellkraft den Schnittdruck des Meißels überwiegt, erfolgt die Schließung des Absperrventiles. Durch Wahl der Querschnittsverhältnisse kann nun die Rückstellkraft so bemessen werden, daß das Absperrventil nur so lange offengehalten wird solange eine Kühlung des Meißels und der Ortsbrust erforderlich ist, wobei ein Wasserverlust während der übrigen Zeit mit Sicherheit vermieden wird.

In der Zeichnung ist die Erfindung anhand eines Ausführungsbeispieles schematisch erläutert.

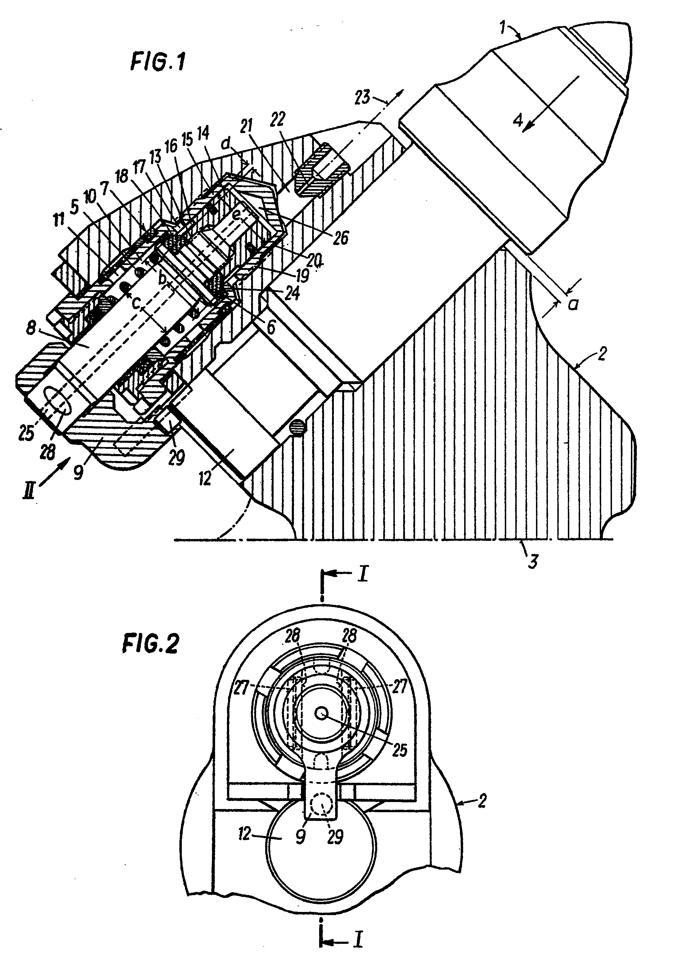

Figur 1 zeigt einen Schnitt durch den Meißelhalter und durch das Ventil in der Achse des Meißels und des Ventils nach Linie I-I der Fig. 2.

Figur 2 zeigt eine Ansicht in Richtung des Pfeiles II der Fig. 1.

Der Meißel 1 ist in einem Meißelhalter 2 axial um einen Weg a verschiebbar gelagert. 3 ist die Fläche des Meißelhalters, an welcher dieser mit dem Schrämkopf einer Schrämmaschine verschweißt ist. Der Meißel 1 ist entgegen dem in Richtung des Pfeiles 4 wirkenden Schnittdruck durch einen Finger 9 belastet, der mit dem Schaft 8 eines Ventilkegels 6 eines Ventiles 7 verbunden ist. Der Finger 9 wirkt über ein Druckstück 29 auf den Meißelschaft 12. Das Druckwasser wird dem Raum 10 vor dem Ventilkegel 6 durch Öffnungen 11 über nicht dargestellte Kanäle im Schrämkopf und im Meißelhalter zugeführt und wirkt daher auf den Ventilkegel 6 im Schließsinne. Des weiteren ist der Ventilkegel 6 durch eine Feder 5 belastet, welche gleichfalls im Schließsinne wirkt. Die über den Finger 9 auf den Meißel 1 entgegen dem in Richtung des Pfeiles 4 wirkenden Schnittdruck wirkende Kraft setzt sich daher aus der durch den Wasserdruck ausgeübten Kraft und der Kraft der Feder 5 zusammen.

Mit dem Ventilkegel 6 ist ein Kolben 14 durch ein Schraubengewinde 13 verbunden, der in einem Zylinder 15 dicht geführt ist. Zwischen dem Ventilkegel 6 und dem Kolben 14 ist durch eine Eindrehung ein Raum 16 geschaffen, in welchen Austrittsöffnungen 17 für das Wasser münden. Bei vom Sitz 18 abgehobenem Ventilkegel 6 strömt das Druckwasser aus dem Raum 10 in den Raum 16, von hier über die Austrittsöffnungen 17 über nicht dargestellte Nuten im Schraubengewinde 19, mit welchem der Zylinder 15 im Meißelhalter festgelegt ist und über einen Spalt 20 zwischen dem Zylinder 15 und der Bohrung des Meißelhalters zum Raum 21 vor der Düse 22. Aus der Düse 22 wird das Wasser in einem scharfen Strahl 23 gegen die Ortsbrust im Bereich des Meißels 1 gespritzt. Der Wasserdruck im Raum 21 ist verhältnismäßig hoch und kann beispielsweise 200 bar betragen.

Bei geschlossenem Ventil, d. h. wenn der Ventilkegel 6 auf dem Ventilstitz 18 aufsitzt wirkt der Wasserdruck im Raum 10 auf eine Ringfläche, deren Größe dem Querschnitt b des äußeren Randes 24 des Ventilsitzes 18 abzüglich des Querschnittes c des Ventilschaftes 8 entspricht. Sobald die durch den Wasserdruck auf den Ventilkegel 6 ausgeübte Kraft zuzüglich der Kraft der Feder 5 durch den in Richtung des Pfeiles 4 wirkenden Schnittdruck überwunden wird, öffnet das Ventil.

Bei geöffnetem Ventil baut sich im Raum 16 ein Wasserdruck auf, welcher um die Strömungsverluste vermindert dem Druck im Raum 10 entspricht. Dieser Wasserdruck wirkt bei geöffnetem Ventil auf eine Ringfläche d, deren Größe dem Querschnitt e des Kolbens 14 abzüglich des Querschnittes c des Ventilschaftes 8 entspricht. Da der Querschnitt c des Ventilschaftes 8 kleiner ist als der Querschnitt e des Kolbens 14, wirkt diese Kraft im Schließsinne des Ventiles. Wenn der Ventilkegel 6 vom Ventilsitz 18 abgehoben ist, setzt sich daher die Rückstellkraft, welche im Schließsinne des Ventils und entgegen dem Schnittdruck (Pfeil 4) wirkt aus der Kraft der Feder 5 und dem auf die Ringfläche d wirkenden Wasserdruck zusammen.

25 ist eine ins Freie mündende Bohrung im Ventilschaft, durch welche der Raum 26 oberhalb des Kolbens 14 drucklos gemacht wird. 27 sind in Nuten 28 des Ventilschaftes 8 eingreifende Keile, durch welche der Ventilschaft 8 mit dem Finger 9 verbunden ist.

Die Querschnitte b, c und d, auf welche der Wasserdruck im Ventil 7 wirkt, sind so bemessen, daß durch den Wasserdruck im wesentlichen die Rückstellkraft aufgebracht wird, welche dem in Richtung des Pfeiles 4 wirkenden Schnittdruck des Meißels 1 entgegenwirkt. Die Feder 5 ist lediglich so stark bemessen, daß sie den Ventilkegel 6 entgegen dem Gewicht des Ventilkegels und des Meißels und entgegen den inneren Reibungswiderständen schließt bzw. in der Schließstellung hält. Hiefür genügt es beispielsweise, wenn diese Feder auf eine Kraft von 120 N vorgespannt ist.

## Ansprüche

1. Einrichtung zum Kühlen der Meißel einer Schrämmaschine mit einer im Bereich des Meißels (1) angeordneten Düse (22) für das unter Druck auszuspritzende Kühlwasser, zu welcher die Wasserzufuhr durch einen Ventilkegel (6) absperrbar ist, wobei der Meißel (1) am Meißelhalter (2) entgegen einer von einer Feder (5) und dem auf den Ventilkegel (6) wirkenden Wasserdruck gebildeten Rückstellkraft durch den Schnittdruck begrenzt axial verschiebbar gelagert ist und der Ventilkegel (6) mit dem Meißel (1) durch ein Kuppelglied (9) derart gekuppelt ist, daß er bei einer Verschiebebewegung des Meißels in Richtung (4) des Schnittdruckes öffnet und bei der bei einer Ausbildung, bei welcher der Ventilkegel (6) erst bei einer vorbestimmten Belastung des Meißels (1) öffnet, der Wasserdruck vor dem Ventilkegel (6) multipliziert mit der durch den Wasserdruck im Schließsinne beaufschlagten wirksamen Fläche (b-c) des Ventilkegels (6) im wesentlichen der Rückstellkraft entspricht und die Feder (5) nur so stark bemessen ist, daß sie bei abgesperrter Wasserzufuhr den Ventilkegel (6) entgegen dem Gewicht des Ventilkegels (6) und des Meißels und entgegen den inneren Reibungswiderständen schließt.

2. Einrichtung nach Anspruch 1, dadurch gekennzeichnet, daß der Ventilkegel (6) in an sich bekannter Weise entgegen der Strömungsrichtung des Wassers öffnet und einen im Ventilgehäuse dicht geführten Ventilschaft (8) aufweist, daß mit dem Ventilkegel (6) ein in Strömungsrichtung hinter demselben angeordneter Kolben (14) starr verbunden ist, der in einem Zylinder (15) des Ventilgehäuses dicht geführt ist, wobei ein Raum (16) zwischen Ventilkegel (6) und Kolben (14) über wenigstens eine Austrittsöffnung (17) für das Wasser mit dem Raum (21) vor der Düse (22) verbunden ist, und daß der Durchmesser (e) des Kolbens (14) größer ist als der Durchmesser (c) des Ventilschaftes (8).

## Claims

1. A device for cooling the bits of a continuous mining machine, comprising a nozzle (22), arranged adjacent the bit (1), for cooling water to be ejected under pressure, the water supply to said nozzle being closable by a valve cone (6), the bit (1) being supported on the bit holder (2) for limited axial shifting movement under the action of the cutting pressure and against a restoring force which is provided by a spring (5) and by the water pressure acting on the valve cone (6), and the valve cone (6) being coupled with the bit (1) by a coupling member (9) such that the valve cone (6) opens upon a shifting movement of the bit in the direction (4) of the cutting pressure, wherein with an arrangement, in which the valve cone (6) opens only at a predetermined load on the bit (1), the water pressure upstream of the valve cone (6) multiplied by the active surface (b-c) of the valve cone (6), which is subjected by the water pressure in the closing direction, essentially corresponds to the restoring force, and the spring (5) has only such a strength that with the water supply being shut off the spring (5) moves the valve cone (6) into its shut-off-position against the weight of the valve cone (6) and the weight of the bit and against the internal frictional resistances.

2. A device as claimes in claim 1, characterised in that the valve cone (6) in a manner known per se is opening in opposite direction to the flow direction of the water and has a valve shaft (8) sealingly guided in the valve housing, that the valve cone (6) is rigidly connected with a piston (14) which is arranged downstream of the valve cone and sealingly guided within a cylinder (15) in the valve housing, there being a space (16) between valve cone (6) and piston (14) which is connected via at least one exit opening (17) for the water with the space (21) upstream of the nozzle (22), and that the piston (14) has a diameter (e) greater than the diameter (c) of the valve shaft (8).

## Revendications

1. Dispositif de refroidissement pour les outils d'une haveuse, comprenant une buse (22) pour l'eau de refroidissement devant être projetée sous pression, qui est disposée dans la région de l'outil (1), et dont l'alimentation en eau peut être arrêtée par un cône de soupape (6), l'outil (1) étant monté sur le porte-outil (2) de façon à coulisser axialement sur une course limitée sous l'effet de la pression de coupe, contre une force de rappel développée par un ressort (5) et par la pression de l'eau agissant sur le cône de soupape (6), et le cône de soupape (6) étant accouplé par un organe d'accouplement (9) de manière à s'ouvrir lors d'un mouvement de translation de l'outil dans le sens (4) de la pression de coupe, et dans lequel, dans une configuration dans laquelle le cône de soupape (6) ne s'ouvre qu'en réponse à une charge prédéterminée de l'outil (1), la pression de l'eau en amont du cône de soupape (6) multipliée par la surface effective (b-c) du cône de soupape (6) qui est repoussée par la pression de l'eau dans le sens de la fermeture, correspond pour l'essentiel à la force de rappel et le ressort (5) n'est que suffisamment fort pour fermer le cône de soupape (6) en surmontant le poids du cône de soupape (6) et de l'outil et en antagonisme aux résistances de frottement internes lorsque l'arrivée de l'eau est interrompue.

2. Dispositif selon la revendication 1, caractérisé en ce que le cône de soupape (6) s'ouvre d'une façon connue en soi en sens inverse du sens de l'écoulement de l'eau et comporte une tige de soupape 8 guidée de manière étanche dans le corps de soupape, en ce qu'au cône de soupape est relié rigidement un piston (14), disposé en aval de ce cône dans le sens de l'écoulement, qui est guidé de manière étanche dans un cylindre (15) du corps de la soupape, une chambre (26) située entre le cône (6) de la soupape et le piston (14) étant reliée à la chambre (21) située en amont de la buse (22) par au moins un orifice de sortie (17) pour l'eau et en ce que le diamètre (e) du piston (14) est plus grand que le diamètre (c) de la tige (8) de la soupape.

**FIG.1**

**FIG.2**